Europäisches Patentamt

European Patent Office

Office européen des brevets

(19)

(11) Veröffentlichungsnummer: **0 235 770 B1**

(12) **EUROPÄISCHE PATENTSCHRIFT**

(45) Veröffentlichungstag der Patentschrift: **18.03.92**

(51) Int. Cl.⁵: **H01J 37/32**, H01J 37/34, C23C 14/34

(21) Anmeldenummer: **87102866.8**

(22) Anmeldetag: **27.02.87**

(54) **Vorrichtung zur Plasmabehandlung von Substraten in einer durch Hochfrequenz angeregten Plasmaentladung.**

(30) Priorität: **04.03.86 DE 3606959**

(43) Veröffentlichungstag der Anmeldung:
**09.09.87 Patentblatt 87/37**

(45) Bekanntmachung des Hinweises auf die Patenterteilung:
**18.03.92 Patentblatt 92/12**

(84) Benannte Vertragsstaaten:
**AT BE CH DE ES FR GB IT LI LU NL SE**

(56) Entgegenhaltungen:
**EP-A- 0 210 858
DE-A- 2 115 590
GB-A- 2 077 030**

(73) Patentinhaber: **LEYBOLD AKTIENGESELL-SCHAFT
Wilhelm-Rohn-Strasse 25
W-6450 Hanau am Main 1(DE)**

(72) Erfinder: **Kieser, Jörg, Dr. Dipl.-Phys.
Goldbergstrasse 4a
W-8755 Albstadt(DE)**
Erfinder: **Sellschopp, Michael, Dr. Dipl.-Phys.
Köhler Weg 83
W-6451 Hammersbach(DE)**
Erfinder: **Geisler, Michael Dr. Dipl.-Phys.
Chatilloner Strasse 29
W-6480 Wächtersbach(DE)**

(74) Vertreter: **Zapfe, Hans, Dipl.-Ing.
Am Eichwald 7
W-6056 Heusenstamm 2 Rembrücken(DE)**

## Beschreibung

Die Erfindung betrifft eine Vorrichtung zur Plasmabehandlung von Substraten in einer durch Hochfrequenz angeregten Plasmaentladung zwischen zwei durch eine Hochfrequenzquelle versorgten Elektroden, von denen die erste als Hohlanode ausgebildet und die zweite, das Substrat tragende Elektrode, dem Hohlraum der Anode vorgelagert oder an diesem vorbeiführbar ist, wobei die Hohlanode eine in Richtung auf die zweite Elektrode vorgezogene, auf gleichem Potential wie die Hohlanode liegenden Rand aufweist, der gegenüber der zweiten Elektrode allseitig einen Spalt "$s_1$" von maximal 10 mm Breite bildet.

Bei der Plasmabehandlung, für die die Vorrichtung vorgesehen ist, kann es sich um Plasmaätzen, um die Herstellung von Polymerschichten auf den Substraten durch Plasmapolymerisation, um die Aktivierung von Substratoberflächen etc. handeln.

Oblicherweise enthalten Vorrichtungen zur Plasmabehandlung von Substraten mittels Hochfrequenz zwei Elektroden, von denen die eine durch die Vakuumkammer und/oder durch den Substrathalter gebildet wird, die beide aus metallischen Werkstoffen bestehen. Es ist bekannt, daß sich dabei jeweils an derjenigen Elektrode eine gegenüber dem Plasma überwiegend negative Spannung ausbildet, die in Bezug auf die als Gegenelektrode wirkenden Oberflächen die kleinere wirksame Oberfläche aufweist. Die negativ vorgespannte Elektrode wird daher auch hier regelmäßig als "Katode" bezeichnet.

Bei Verwendung eines plattenförmigen Substrathalters, der mit der Vakuumkammer auf gleichem Potential liegt und damit die eine Elektrode bildet, einerseits, und bei Verwendung einer plattenförmigen, dem Substrathalter gegenüberliegenden Elektrode andererseits, bildet sich aufgrund der hierdurch notwendigerweise vorgegebenen Flächenverhältnisse an der zuletzt genannten Elektrode das negative Potential aus. Dadurch wird auf dieser Elektrode (= Katode) befindliches Material (= Target) zerstäubt und auf dem Substrat niedergeschlagen. Will man in einer solchen Vorrichtung ätzen, so müssen Substrate und Target sinngemäß vertauscht werden.

Bei Verwendung von Gleichspannung ist die Polarität der Elektroden durch ihre Verbindung mit dem jeweiligen Pol der Gleichspannungsquelle zwingend vorgegeben. Durch die DE-OS 21 15 590 ist es beispielsweise bekannt, eine Hohlkatode mit einem in Richtung auf den Substratträger vorspringenden Rand zu verwenden, um die Gleichmäßigkeit der Schichtdickenverteilung zu verbessern. Dieser vorspringende Rand führt aber bei Verwendung von Gleichspannung nicht zu einer Umkehrung der Polarität.

Durch die DE-PS 22 41 229 ist eine Vorrichtung gemäß Gattungsbegriff bekannt, bei der durch Verwendung von Hochfrequenz erreicht wird, daß die hohle Elektrode wegen ihres Randes relativ zu der dem Hohlraum unmittelbar zugekehrten Oberfläche der anderen Elektrode (des Substrathalters) die größere Oberfläche aufweist und hierdurch die Funktion einer Anode erhält, so daß also gewissermaßen eine Umkehrung der Verhältnisse bezüglich der Vorspannung erfolgt. Dies läßt sich vereinfacht so erklären, daß der Rand der Hohlanode einen Entladungsraum eingrenzt, relativ zu welchem die außerhalb liegenden metallischen Teile der Vorrichtung keine Elektrodenfunktion mehr ausüben, so daß die Verhältnisse ausschließlich durch die einander zugekehrten Oberflächenteile der Hohlanode einerseits und des Substrathalters andererseits bestimmt werden. Man kann dies ald "Randeffekt" bezeichnen.

Die bekannte Lösung führt jedoch im Falle einer Anwendung dieses Prinzips bei bestimmten Vorrichtungen mit kontinuierlichem Substrattransport zu einigen Schwierigkeiten: Wird nämlich der Substrathalter mit dem Substrat entfernt, so wirkt als Gegenelektrode mindestens die metallische Grundplatte der Vakuumkammer, die in der Regel eine größere Fläche als die hohle Elektrode besitzt und an Masse gelegt ist. In diesem Fall bildet sich in völliger Umkehrung der Potentialverhältnisse die negative Spannung auf der Hohlelektrode aus, die nunmehr als Katode wirkt.

Daraus ergibt sich, daß die Größe des Spaltes zwischen dem Rand der Hohlelektrode einerseits und dem Substrat bzw. Substrathalter andererseits von wesentlicher Bedeutung für die Ausbildung der Potentialverteilung im Bereich des vom Plasma erfüllten Raumes ist. Da der erwähnte Spalt die Verbindung des Plasmas zu dessen Umgebung darstellt, entscheidet die Spaltgröße darüber, ob die Hohlelektrode als Anode oder als Katode der Anordnung wirkt. Durch Versuche wurde festgestellt, daß eine Vergrößerung des genannten Spaltes über einen Betrag von etwa 1 mm hinaus den Einfluß der übrigen metallischen Vorrichtungsteile drastisch vergrößert, und zwar mit der Konsequenz der Ausbildung einer negativen Vorspannung auf der Hohlelektrode anstatt auf dem Substrat. Derartige Spaltvergrößerungen sind nun aber bei kontinuierlichen Vorrichtungen, bei denen die Substrate auf beweglichen Substrathaltern angeordnet sind, praktisch unvermeidbar, insbesondere dann, wenn derartige Substrathalter mit Abständen zueinander an der Öffnung der Hohlelektrode vorbeigeführt werden. Auch kann der betreffende Spalt nicht beliebig klein gehalten werden, da dies nicht nur eine außerordentlich präzise Führung der Substrathalter erforderlich macht, sondern weil auch die gegebenenfalls auf der Oberfläche des Substrathalters liegenden Substrate bei ihrem Durchlauf durch die Anlage die Spaltweite verändern, wenn man nicht den sehr aufwendigen Weg geht, für jede Substratform und -größe unterschiedliche Substrathalter einzusetzen, in denen die Substrate vertieft und bündig mit der Oberfläche des Substrathalters angeordnet sind. Damit wird die Anwendungsbreite des bekannten Prinzips stark eingeschränkt.

Der Erfindung liegt daher die Aufgabe zugrunde, eine Vorrichtung der eingangs beschriebenen Gattung dahingehend zu verbessern, daß sie unempfindlicher gegen eine Vergrößerung des Spaltes ist und insbesondere auch in Vorrichtungen mit kontinuierlichem oder quasikontinuierlichem Substrattransport eingesetzt werden kann, d.h. in sogenannten "In-Line-Anlagen".

Die Lösung der gestellten Aufgabe erfolgt bei der eingangs angegebenen Vorrichtung erfindungsgemäß dadurch, daß im Hohlraum der Hohlanode an deren innerer Oberfläche oberflächenvergrößernde Vorsprünge angeordnet sind.

Durch diese Vorsprünge wird die dem Plasma zugekehrte Oberfläche der Hohlanode erheblich vergrößert, so daß der Plasmaeinschuß auch bei einer merklichen Vergrößerung der Spaltweite erhalten bleibt und auch dann noch keine Umkehrung der Potentialverhältnisse erfolgt, wenn fahrbare oder verschiebbare Substrathalter relativ zur Öffnung der Hohlanode transportiert werden. Die geometrische Form der Vorsprünge ist dabei nicht kritisch; sie sollen lediglich eine möglichst große Oberflächenvergrößerung bewirken, wobei allerdings die Abstände der Vorsprünge untereinander bzw. die zwischen den Vorsprüngen und dem Rand gebildeten Hohlräume nicht so klein dimensioniert werden dürfen, daß die Oberflächenvergrößerung in Bezug auf das Plasma unwirksam würde. Die Abstände dürfen also das zweifache Maß des sogenannten "Dunkelraumabstandes" nicht unterschreiten. Weiterhin hat die Vergrößerung der inneren Oberfläche der Hohlanode eine Vergrößerung der sich auf der Oberfläche des Substrats bzw. des Substrathalters, relativ zur Hohlanode ausbildenden negativen Spannung zur Folge. Hieraus resultiert eine entsprechende Erhöhung der kinetischen Energie der aus dem Plasmaraum auf das Substrat auftreffenden, positiv geladenen Ionen.

Dies führt für den Fall der Verwendung der erfindungsgemäßen Vorrichtung als Ätz vorrichtung in einer Erhöhung der spezifischen Ätzrate. Für den Fall der Abscheidung von Schichten aus der Gasphase führt der Beschuß der auf dem Substrat aufwachsenden Schicht mit positiven Ionen wegen des gleichzeitigen Absputterns der schwächer gebundenen Teilchen der Schicht zu besonders hochwertigen Schichten.

Durch die erfindungsgemäße Maßnahme bleiben die Eigenschaften der Hohlanode auch bei einem laufenden Substrattransport voll erhalten: Das Plasma ist durch materielle Wände vollständig eingeschlossen, im Gegensatz beispielsweise zu einem Einschluß durch Magnetfelder, der insbesondere bei Anwendung von Hochfrequenz nie vollständig ist. Weiterhin wird durch den vollständigen Einschluß durch die Hohlanode im Plasmaraum eine Plasmadichte erreicht, die bei einem Plasmaeinschluß mittels magnetischer Felder nicht erreichbar ist, vergleichbare elektrische Leistungen pro Flächeneinheit vorausgesetzt. Darüberhinaus haben Untersuchungen gezeigt, daß die Plasmadichte im gesamten Hohlraum der Hohlanode mit Ausnahme einer Abnahme im unmittelbaren Randbereich so gleichmäßig ist, daß eine Abweichung optisch nicht beobachtet werden kann. Der Abfall der Plasmadichte im Randbereich beschränkt sich auf weniger als 5 mm. Dies führt zu Schichtdickenabweichungen, die kleiner als $\pm$ 3 % sind, ein Wert, der mit einem magnetischen Einschluß des Plasmas nicht erreicht werden kann.

Die erfindungsgemäße Ausbildung der Anode ist dabei leicht durchzuführen, und zwar durch ein Gießverfahren oder durch Zusammensetzung aus metallischem Streifenmaterial. Auch kann die erfindungsgemäße Hohlanode leicht gegen eine solche nach dem Stand der Technik ausgetauscht werden, ohne daß es umständlicher Umbauten an der gesamten Vorrichtung bedarf.

Die erfindungsgemäße Vorrichtung eignet sich für die Plasmapolymerisation, d.h. für die Abscheidung von Polymerisatschichten auf den Substraten, insbesondere aber für die Abscheidung von amorphem Kohlenstoff als Schutzschicht auf Substraten. Für die zuletzt genannten Zwecke wird ein gasförmiger Kohlenwasserstoff in den Hohlraum der Hohlanode eingeleitet, wobei die Abfuhr der Reaktionsprodukte (hauptsächlich Wasserstoff) auf weiter unten noch näher beschriebenen Wegen geschieht.

Bei Hohlanoden, die in eine Vakuumkammer derart hineinragen, daß auch ihre Außenseiten mindestens teilweise dem Vakuum ausgesetzt sind, ist es erforderlich, daß die Hohlanode auf ihrer Außenseite allseitig von einer Dunkelraumabschirmung umgeben ist, die gleichfalls einen in Richtung auf die zweite Elektrode vorgezogenen, auf gleichem Potential wie die Dunkelraumabschirmung liegenden Rand aufweist. Dabei ist es in weiterer Ausgestaltung der Erfindung besonders vorteilhaft, wenn der Rand der Dunkelraumabschirmung gegenüber der zweiten Elektrode (dem Substrathalter) allseitig einen Spalt "$s_2$" von maximal 10 mm bildet.

Eine derartige Vorrichtung kann gemäß der wiederum weiteren Ausgestaltung der Erfindung zusätzlich dadurch gekennzeichnet sein, daß auf mindestens einem Teil des Umfangs der Dunkelraumabschirmung elektrische Koppelelemente angeordnet sind, die im Abstand des Spaltes "$s_2$" im wesentlichen parallel zur benachbarten Oberfläche der zweiten Elektrode verlaufen. Derartige Koppelelemente bringen den zusätzlichen Vorteil mit sich, daß der Spalt "$s_1$" noch größer dimensioniert werden kann bevor der "Randeffekt" verschwindet.

Beispiele und Möglichkeiten zur geometrischen Ausbildung dieser Koppelelemente sind in der Detailbeschreibung näher erläutert. Zur Erläuterung ihrer Bedeutung sei nochmals auf den Stand der Technik nach der DE-PS 22 41 299 hingewiesen.

Trotz direkter Verbindung des Substrathalters mit dem Hochfrequenz-Massepunkt, d.h. mit der metallischen Vakuumkammer, durch eine beidseitig verschraubte Kupferlitze großen Querschnitts lag der Substrathalter keineswegs auf Massepotential, was an der Ausbildung einer geschlossenen Plasmazone um den gesamten Substrathalter erkennbar war. Die Verhältnisse sind bei Anlagen mit beweglichen Substrathaltern noch weitaus schwieriger zu beherrschen, da dort eine Masseverbindung durch feste Anschlüsse ohnehin nicht herzustellen ist.

Durch die erfindungsgemäße Anordnung von Koppelelementen, die vorzugsweise aus Blechen bestehen, die parallel zur benachbarten Oberfläche des Substrathalters verlaufen, wird unter Hochfrequenzbedingungen eine Ankopplung des Substrathalters an die Dunkelraumabschirmung erreicht, wodurch der Einschluß des Plasmas noch weiter verbessert wird. Bei genügender Länge bzw. Breite der Koppelelemente von beispielsweise 10 cm, konnte sogar bei einem ansonsten isoliert aufgestellten Substrathalter ein einwandfreier Einschluß des Plasmas mit einer negativen Vorspannung am Substrathalter erreicht werden, und zwar für Abstände $s_2$ bis zu 3 mm.

Der Einschluß des Plasmas und die volle negative Vorspannung des Substrathalters blieben bei verfahrbaren Substrathaltern selbst dann erhalten, wenn die eine Kante des Substrathalters den Hohlraum der Hohlanode gerade eben abdeckte. Bei einer Oberflächengröße der Koppelelemente von 800 cm$^2$ und einem Abstand $s_2$ von 0,3 cm wird beispielhaft ein Plattenkondensator mit einer Kapazität von 235 pF gebildet, woraus sich für die übliche Frequenz von 13,56 MHz ein Wechselstromwiderstand von R = 313 Ohm errechnet. Bei den üblichen Bias-Spannungen von 1 kV können somit über diese Kapazität ohne weiteres Leistungen in der Größenordnung von 1 bis 2 kW übertragen werden. Erst ab einer Leistung von etwa 1,5 kW (entsprechend einer Flächenleistung von ca. 4 W/cm$^2$ Substratfläche konnte eine, allerdings extrem schwache, Plasmaausbildung um den Substrathalter beobachtet werden, was jedoch keine erkennbaren Auswirkungen auf die Polaritäts-Verhältnisse im Plasmaraum hatte, d.h. die über die Koppelelemente bewirkte rein kapazitive Ankopplung des Substrathalters an den Hochfrequenz-Nullpunkt war wesentlich wirksamer als die beim Stand der Technik übliche Verbindung über eine Kupferlitze. Dabei ist ein Spalt $s_2$ in der Größenordnung von 3 mm ohne weiteres auch für sehr große Substrathalter realisierbar.

Weitere vorteilhafte Ausgestaltungen des Erfindungsgegenstandes sind in den übrigen Unteransprüchen angegeben bzw. in der nachstehenden Detailbeschreibung näher erläutert.

Es zeigen:

Figur 1 einen vertikalen Axialschnitt durch eine vollständige Vorrichtung für den Durchlauf plattenförmiger Substrathalter,

Figur 2 eine Unteransicht der Hohlanode aus der Ebene II-II in Figur 1m

Figur 3 eine Unteransicht analog Figur 2, jedoch mit zweifach verschiedener Ausbildung der Vorsprünge innerhalb der Hohlanode,

Figur 4 eine perspektivische Darstellung einer Hohlanode mit einem Koppelelement, aufgeschnitten entlang einer Symmetrieebene der Hohlanode,

Figur 5 ein Detail aus Figur 4 in perspektivischer Darstellung in vergrößertem Maßstab,

Figur 6 eine Anordnung analog Figur 4 jedoch mit einem walzenförmigen Substrathalter für die Plasmabehandlung von flexiblen, bandförmigen Substraten und

Figur 7 eine Verdoppelung der Vorrichtung nach Figur 4 in spiegelsymmetrischer Anordnung.

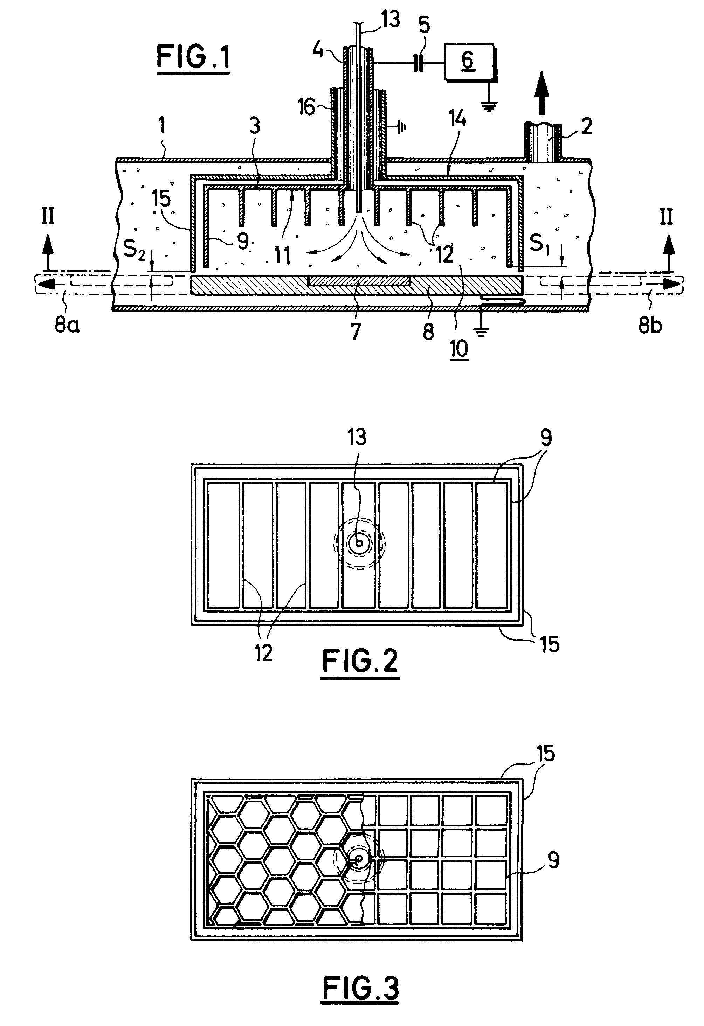

In Figur 1 ist eine Vakuumkammer 1 dargestellt, die über einen Saugstutzen 2 auf einen für derartige Plasmaprozesse üblichen Druck evakuierbar ist. In die Decke der Vakuumkammer ist eine Hohlanode 3 eingesetzt, die über eine elektrisch leitende Tragvorrichtung 4 und einen Kondensator 5 mit einer Hochfrequenzquelle 6 verbunden ist. Unterhalb der Hohlanode 3 befindet sich eine zweite, ein Substrat 7 tragende Elektrode 8, die einen der Substrathalter bildet. Die Hohlanode besitzt auf ihrem gesamten (rechteckigen) Umfang einen in Richtung auf die Elektrode 8 vorgezogenen und auf gleichem Potential wie die Hohlanode 3 liegenden Rand 9, der gegenüber der zweiten Elektrode allseitig einen Spalt "$s_1$" von 2 mm bildet.

Die Hohlanode 3 umschließt infolgedessen einen Hohlraum 10, dessen innere Oberfläche 11 durch Vorsprünge 12 vergrößert ist, die durch parallele Rippen gebildet werden (siehe auch Figur 2). Für den Abstand dieser Vorsprünge gilt, daß dieser wesentlich größer sein muß, als der zweifache Dunkelraumabstand bei dem angewandten Vakuum, was bei Vakua von ca. $2 \times 10^{-2}$ mbar zu einem praktisch brauchbaren Abstand der Vorsprünge voneinander und vom Rand 9 von etwa 20 mm führt. Die Höhe der Rippen ist hierbei nicht beschränkt, sie sollte jedoch im Interesse einer guten Homogenität der Gaszusammensetzung im Bereich des Substrats 7 nicht größer sein, als etwa die Hälfte der Höhe des Randes 9. Diese Verhältnisse sind in Figur 1 etwa maßstäblich dargestellt.

Für die Einführung entsprechender Behandlungsgase ist eine Gas-Zuleitung 13 vorgesehen, die mit einer nicht dargestellten Quelle für das einzusetzende Gas verbunden ist. Die Gaszuleitung 13 mündet in den Hohlraum 10, wobei die Gasverteilung noch durch ein hier nicht gezeigtes Verteilerrohr verbessert werden kann, das sich über einen größeren Teil der Länge oder Breite des Hohlraums 10 erstreckt und auf seiner gesamten Länge eine Vielzahl von Austrittsbohrungen aufweist. Die untere umlaufende (rechteckige) Kante des Randes 9, die gleichzeitig den Spalt mit der Weite "$s_1$" definiert, ist die Öffnung der Hohlanode 3.

Die Hohlanode 3 ist - mit Ausnahme der unteren Öffnung - allseitig von einer quaderförmigen Dunkelraumabschirmung 14 umgeben, deren Rand 15 gegenüber der zweiten Elektrode 8 einen Spalt "$s_2$" mit einer Breite von 2 mm bildet. Der Ein- und Austritt der nicht verbrauchten Reaktionsprodukte der zugeführten Gase erfolgt über die Spalte $s_1$ und $s_2$. Die Dunkelraumabschirmung 14 ist über eine weitere Tragvorrichtung 16 mit der Vakuumkammer 1 elektrisch leitend verbunden und liegt infolgedessen mit der Vakuumkammer auf Massepotential.

Am jeweils linken und rechten Ende ist die Vakuumkammer 1 mit je einer hier nicht dargestellten Vakuumschleuse verbunden, durch die die als Substrathalter dienenden Elektroden 8 sequentiell in die Anlage eingeführt und aus dieser wieder herausgeführt werden. Die Elektrode 8 ist auf ihrem Wege in zwei weiteren Positionen 8a und 8b gestrichelt dargestellt.

Die Figur 3 zeigt zwei weitere Varianten der Vorsprünge 12 in Figur 1, und zwar sind in der linken Hälfte von Figur 3 Vorsprünge dargestellt, die sich zu einem Wabenmuster ergänzen, während in der rechten Hälfte von Figur 3 Vorsprünge dargestellt sind, die als sich kreuzende Scharen von Rippen ausgebildet sind.

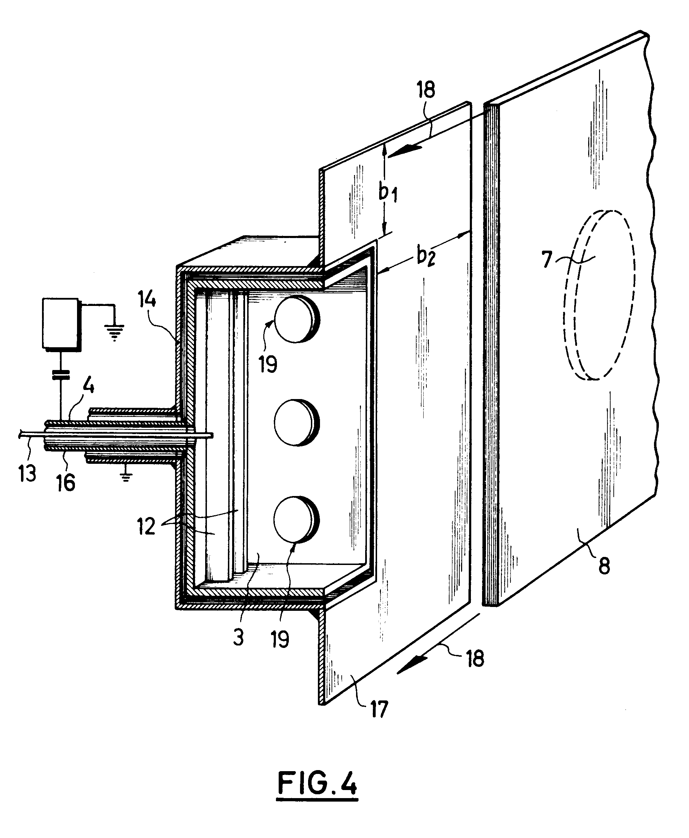

Figur 4 zeigt eine entlang ihrer einen Symmetrieebene aufgeschnittene Hohlanode 3 mit Vorsprüngen 12 und einer Dunkelraumabschirmung 14 in völliger Analogie zu Figur 1. Auf dem Umfang der Dunkelraumabschirmung 14, die gleichfalls entlang ihrer einen Symmetrieebene aufgeschnitten dargestellt ist, befindet sich ein elektrisches Koppelelement 17, das in Form eines rechteckigen, ebenen Rahmens ausgebildet ist, der aus Metall besteht und elektrisch leitend mit der Dunkelraumabschirmung 14 verbunden ist. Die Rahmenbreite $b_1$ und $b_2$ liegt dabei zwischen etwa 4 und 12 cm. Die Anordnung ist dabei so getroffen, daß das Koppelelement 17 exakt bündig mit der offenen Unterseite bzw. Kante der Dunkelraumabschirmung 14 abschließt. Die das Substrat 7 tragende Elektrode 8 wird im Abstand des Spaltes $s_2$ parallel zum Koppelelement 7 in Richtung der beiden Pfeile 18 an der Öffnung der Hohlanode 3 vorbeigeführt, wobei es zum Zwecke einer völlig ausreichenden elektrischen Ankopplung der Elektrode 8 bereits genügt, wenn diese Elektrode drei Umfangsseiten des Koppelelements 17 überdeckt.

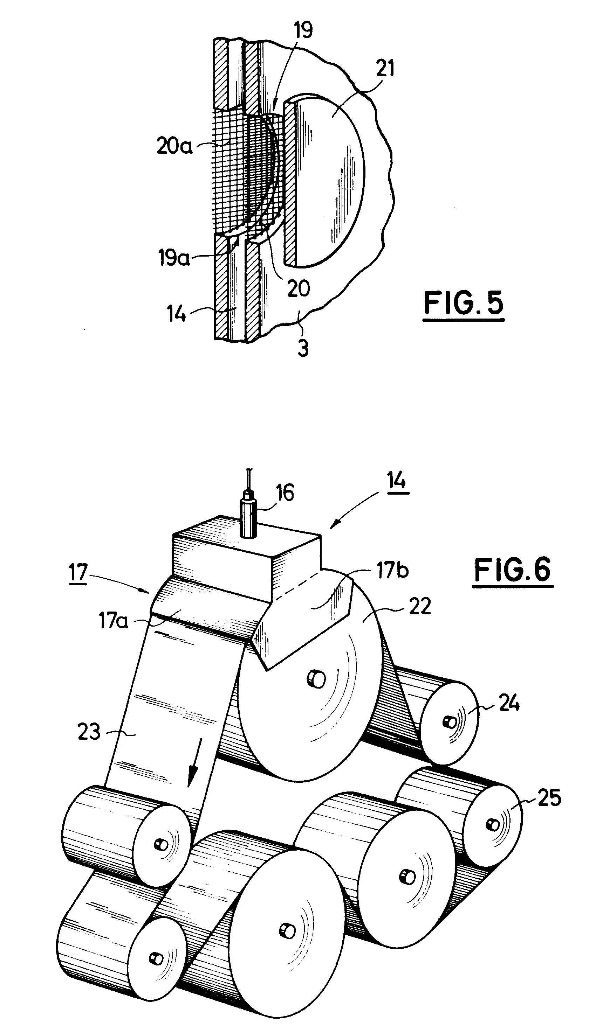

Wie aus Figur 4 ferner hervorgeht, befinden sich in den Wandflächen der Hohlanode 3 und der Dunkelraumabschirmung 14 Öffnungen 19 für den Austritt der nicht verbrauchten Reaktionsprodukte der zugeführten Gase. Einzelheiten dieser Öffnungen 19 werden anhand von Figur 5 nunmehr näher erläutert.

Figur 5 zeigt in vergrößertem Maßstab Ausschnitte aus Wandungsteilen, nämlich aus den Rändern der Hohlanode 3 und der Dunkelraumabschirmung 14. Die miteinander fluchtenden Öffnungen 19 und 19a sind durch hochfrequenzundurchlässige Gitter 20 bzw. 20a versehen, vor denen jeweils ein Abschirmelement 21 in Form einer Kreisscheibe angeordnet ist, und zwar dem Hohlraum 10 zugekehrt. Dadurch wird das Plasma in gleicher Weise wie durch eine feste Wand eingeschlossen, wobei jedoch der Gastransport praktisch nicht behindert wird. Für die vorzugsweise zu verwendende Frequenz von 13,56 MHz kommen hierfür handelsübliche Metallnetze mit einer lichten Weite zwischen den Maschen von einigen Zehntel Millimetern in Frage. Der optische Transmissionsgrad solcher Netze beträgt zwischen 40 und 70 %. Das Abschirmelement 21 dient dazu, das Zerstäuben der Gitter beim offenen Betrieb der Hohlanode (ohne Elektrode 8 vor der Hohlanode) zu verhindern. Der Abstand dieses Abschirmelements von der zugeordneten Oberfläche der Hohlanode 3 beträgt etwa 5 mm.

Figur 6 zeigt eine Variante des Gegenstandes nach Figur 4, bei der die zweite Elektrode 22 aus einer metallischen Kühlwalze besteht, über die ein bandförmiges Substrat 23 geführt wird, das von einer Vorratsrolle 24 kommt und zu einer Aufwikkelrolle 25 geführt wird. Die übrigen, dazwischenliegenden Walzen sind entweder Führungswalzen oder Kühlwalzen für weitere Behandlungen, die jedoch hier nicht weiter interessieren. Von der Hohlanode ist hier nur die Dunkelraumabschirmung 14 dargestellt, die ebenso wie die nicht gezeigte Hohlanode der zylindrischen Kontur der Elektrode 22 angepaßt ist. Um hierbei die axiale Ausdehnung der Anordnung gering zu halten, ist das elektrische Koppelelement 17 aus mehreren Teilen zusammengesetzt. Im Bereich der Zylinderfläche der Elektrode 22 besitzt das Koppelelement 17 auf jeder Seite ein zylindrisches Teilstück 17a, von dem in Figur 6 nur das vordere zu sehen ist. Im Bereich der kreisförmigen Stirnflächen der zweiten Elektrode 22 besteht das Koppelelement 17 aus zwei ebenen Teilstücken 17b, von denen ebenfalls nur das vordere sichtbar ist. Die Teilstücke 17a und 17b genügen jedoch sämtlich der Forderung, daß sie im Abstand des Spaltes $s_2$ im wesentlichen parallel zur benachbarten Oberfläche der zweiten Elektrode 22 verlaufen.

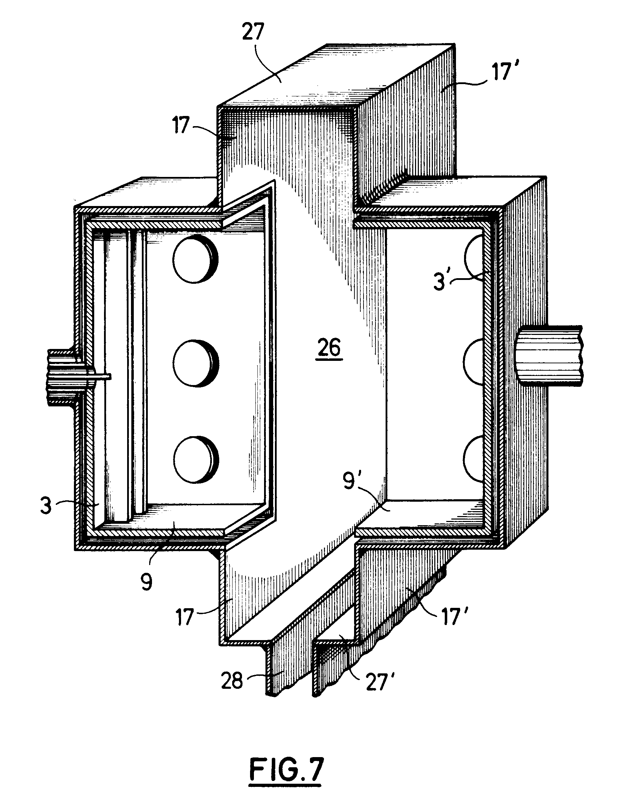

Figur 7 zeigt die spiegelsymmetrische Verdoppelung der Vorrichtung nach Figur 4, und zwar ist der Hohlanode 3 gegenüber eine zweite Hohlanode 3' derart angeordnet, daß ihre Ränder 9 bzw. 9' miteinander fluchten und die Koppelelemente 17 bzw. 17' einen Zwischenraum 26 zwischen sich einschliessen, der zum Hindurchführen entsprechend geformter Substrate dient und zwar mit oder ohne einen besonderen Substrathalter. Bei Verzicht auf einen solchen übernimmt das Substrat die Rolle der zweiten Elektrode. Die erforderlichen Führungseinrichtungen sind der Einfachheit halber nicht dargestellt. Die Koppelelemente 17 und 17' sind durch eine Zarge 27 bzw. 27' mehr oder weniger, jedenfalls aber elektrisch leitend, miteinander verbunden, wobei in der unteren Wand der Zarge 27' ein Schlitz 28 für den Durchgriff einer nicht gezeigten Transporteinrichtung vorhanden ist.

In den nicht sichtbaren, vorderen und hinteren Wänden der Zarge 27 bzw. 27' befinden sich übliche Öffnungen. Die Hohlanode 3' kann eine eigene Hochfrequenzquelle aufweisen, oder an die Hochfrequenzquelle 6 der Hohlanode 3 angeschlossen sein. Auch können die Hohlanoden 3 und 3' zu einem Anodenkasten miteinander vereinigt sein, der lediglich Ein- und Austrittsöffnungen für die Substrate bzw. die zweite Elektrode aufweist.

Beispiel 1:

Bei einer Vorrichtung nach Figur 4 besaß die Öffnung der Hohlanode 3 die Abmessungen 40 cm x 10 cm. Eine Argonatmosphäre wurde bei einem Druck von $2 \times 10^{-2}$ mbar aufrechterhalten, und die Hohlanode wurde mit einer Frequenz von 13,56 MHz und einer Leistung von insgesamt 420 Watt betrieben. Die zweite Elektrode 8 befand sich zu diesem Zeitpunkt noch nicht vor der Öffnung, so daß die "Hohlanode" als Katode betrieben wurde, was an der Ausbildung eines deutlich sichtbaren Plasmas im Bereich der Öffnung erkennbar war. Eine Biasspannung war nicht meßbar. Danach wurde die zweite Elektrode 8, auf der sich ein aus Metall bestehendes Substrat 7 befand, vor die Katode gefahren. In dem Augenblick, in dem die Hohlanode 3 gerade eben von der Elektrode 8 abgedeckt wurde, sprang die in das Plasma eingekoppelte Leistung auf den vorher eingestellten Sollwert von 1 kW. Dies entsprach einer Flächenleistung auf der unter der Hohlanode liegenden Substratfläche von 2,5 W/cm². Gleichzeitig baute sich eine Gleichspannung von 1 kV zwischen der Hohlanode und dem Substrat auf, wodurch das Substrat negativ vorgespannt wurde. In dieser Position wurde die Elektrode 8 angehalten und das Substrat geätzt. Eine anschliessende Untersuchung des Substrats ergab, daß die Ätzrate 1,0 nm/s betrug.

Beispiel 2:

In der gleichen Vorrichtung wurde dynamisch ein Druck von $3 \times 10^{-2}$ mbar Acethylen ($C_2H_2$) aufrechterhalten. In analoger Weise wie in Beispiel 1 war in der Öffnung der Hohlanode nach dem Einschalten der Hochfrequenz-Quelle ein Plasma sichtbar, und es wurde eine Leistung von gleichfalls 420 Watt eingestellt, ohne daß eine Bias-Spannung feststellbar war. Nach dem Vorfahren der Elektrode 8 vor die Hohlanode sprang die in das Plasma eingekoppelte Leistung auf den zuvor eingestellten Soll-Wert von 1 kW , entsprechend einer Flächenleistung von gleichfalls 2,5 W/cm². Die Biasspannung betrug in diesem Falle 600 V. Dieser Vorgang wurde für die Dauer von 100 s fortgesetzt. Die anschliessende Prüfung ergab eine Schicht aus amorphem Kohlenstoff mit einer Dicke von 300 nm, entsprechend einer statischen Beschichtungsrate von 3 nm/s. Die von der Substratoberfläche und der Schicht erzeugte Interferenzfarbe ergab im gesamten Bereich der Öffnung der Hohlanode bis auf einen schmalen Randbereich von ca. 5 mm Breite keine erkennbaren Abweichungen hinsichtlich der Schichtdicke.

**Patentansprüche**

1. Vorrichtung zur Plasmabehandlung von Substraten in einer durch Hochfrequenz angeregten Plasmaentladung zwischen zwei durch eine Hochfrequenzquelle versorgten Elektroden, von denen die erste als Hohlanode ausgebildet und die zweite, das Substrat tragende Elektrode, dem Hohlraum der Hohlanode vorgelagert oder an diesem vorbeiführbar ist, wobei die Hohlanode einen in Richtung auf die zweite Elektrode vorgezogenen, auf gleichem Potential wie die Hohlanode liegenden Rand aufweist, der gegenüber der zweiten Elektrode allseitig einen Spalt "$s_1$" von maximal 10 mm Breite bildet, dadurch gekennzeichnet, daß im Hohlraum (10) der Hohlanode (3) an deren innerer Oberfläche (11) oberflächenvergrößernde Vorsprünge (12) angeordnet sind.

2. Vorrichtung nach Anspruch 1, dadurch gekennzeichnet, daß die Vorsprünge (12) als von der inneren Oberfläche (11) abstehende Rippen ausgebildet sind.

3. Vorrichtung nach Anspruch 2, dadurch gekennzeichnet, daß zwei sich kreuzende Scharen von Rippen vorgesehen sind.

4. Vorrichtung nach Anspruch 1, dadurch gekennzeichnet, daß die Hohlanode (3) auf ihrer Außenseite allseitig von einer Dunkelraumabschirmung (14) umgeben ist, die gleichfalls einen in Richtung auf die zweite Elektrode vorgezogenen, auf gleichem Potential wie die Dunkelraumabschirmung liegenden Rand (15) aufweist, der gegenüber der zweiten Elektrode (8) allseitig einen Spalt "$s_2$" von maximal 10 mm bildet.

5. Vorrichtung nach Anspruch 4, dadurch gekennzeichnet, daß auf mindestens einem Teil des Umfangs der Dunkelraumabschirmung (4) mindestens ein elektrisches Koppelelement (17, 17a, 17b) angeordnet ist, das im Abstand des Spaltes "$s_2$" im wesentlichen parallel zur benachbarten Oberfläche der zweiten Elektrode (8, 22) verläuft.

6. Vorrichtung nach Anspruch 1, dadurch gekennzeichnet, daß in den Hohlraum (10) mindestens eine Gaszuleitung (13) führt.

7. Vorrichtung nach Anspruch 6, dadurch gekennzeichnet, daß in den Wandflächen der Hohlanode (3) und der Dunkelraumabschirmung (14) Öffnungen (19, 19a) für einen Gasdurchtritt angeordnet sind, in denen sich hochfrequenzundurchlässige Gitter (20, 20a) befinden.

8. Vorrichtung nach Anspruch 7, dadurch gekennzeichnet, daß den hochfrequenzundurchlässigen Gittern (20, 20a) Abschirmelemente (21) zugeordnet sind.

9. Vorrichtung nach Anspruch 1, dadurch gekennzeichnet, daß zur gleichzeitigen beidseitigen Behandlung von Substraten zwei Hohlanoden (3, 3') in spiegelsymmetrischer Anordnung vorhanden sind, die sich zu einer im wesentlichen geschlossenen Kammer ergänzen, und daß die zweite Elektrode (8) bzw. das die zweite Elektrode bildende Substrat (7) in der Symmetrieebene zwischen den Hohlanoden (3, 3') hindurchführbar sind.

10. Vorrichtung nach Anspruch 9, dadurch gekennzeichnet, daß beiderseits der Symmetrieebene Koppelelemente (17, 17') in paralleler Anordnung zueinander und zur zweiten Elektrode (8) bzw. zu den die zweite Elektrode bildenden Substrat (7) angeordnet sind.

11. Anwendung der Vorrichtung nach Anspruch 1 in Verbindung mit der Zuleitung reaktionsfähiger Gase zum Herstellen von aus der Gasphase abgeschiedenen Schichten auf den Substraten.

**Claims**

1. Device for the plasma processing of substrates in a high-frequency-excited plasma discharge between two electrodes supplied by a high frequency source, the first electrode being formed as a hollow anode and the second electrode, which carries the substrate, being mounted in front of the cavity of the hollow anode or being capable of being guided past the latter, the hollow anode having an edge, which is drawn forward in the direction of the second electrode and which has the same potential as the hollow anode, this edge forming a gap "$s_1$" of 10 mm maximum width all round with respect to the second electrode, characterised in that surface area-increasing projections (12) are located in the cavity (10) of the hollow anode (3) around its inner surface (11).

2. Device according to claim 1, characterised in that the projections (12) are formed as fins projecting from the inner surface (11).

3. Device according to claim 2, characterised in that two intersecting groups of fins are provided.

4. Device according to claim 1, characterised in that the hollow anode (3) is surrounded all round its exterior by a dark space screen (14), which also has an edge (15) drawn forward in the direction of the second electrode and having the same potential as the dark space screen, this edge forming a gap "$s_2$" of 10 mm maximum all round with respect to the second electrode (8).

5. Device according to claim 4, characterised in that at least one electric coupling element (17, 17a, 17b) is mounted on at least one part of the circumference of the dark space screen (4) and extends at the distance of the gap "$s_2$" substantially parallel to the adjacent surface of the second electrode (8, 22).

6. Device according to claim 1, characterised in that at least one gas supply line (13) leads into the cavity (10).

7. Device according to claim 6, characterised in that apertures (19, 19a) for the passage of gas are provided in the wall faces of the hollow anode (3) and of the dark space screen (14), in which apertures grids (20, 20a) are located which transmit high frequencies.

8. Device according to claim 7, characterised in that screening elements (21) are associated with the grids (20, 20a) which transmit high frequencies.

9. Device according to claim 1, characterised in that for the simultaneous processing of substrates on both sides, two hollow anodes (3, 3') are provided in a mirror-symmetrical arrangement, and make up a substantially closed chamber, and in that the second electrode (8) or the substrate (7) forming the second electrode can be passed between the hollow anodes (3, 3') in the plane of symmetry.

10. Device according to claim 9, characterised in that on either side of the plane of symmetry coupling elements (17, 17') are provided parallel to one another and to the second electrode (8) or to the substrate (7) forming the second electrode.

11. Application of the device according to claim 1 in connection with the supply of reactive gases for producing on the substrates layers deposited from the gas phase.

**Revendications**

1. Dispositif pour le traitement par plasma de substrats dans une décharge plasmatique excitée par haute fréquence entre deux électrodes alimentées par une source à haute fréquence, la première électrode étant réalisée en tant qu'anode creuse et la deuxième électrode, celle portant le substrat, étant présentée devant la cavité de l'anode creuse ou étant amenée à défiler devant celle-ci, l'anode creuse présentant un bord qui forme saillie en direction de la deuxième électrode et qui est au même potentiel que l'anode creuse et forme de tous côtés, par rapport à la deuxième électrode, un interstice "$S_1$" dont la largeur est au maximum de 10 millimètres, caractérisé, par le fait que des saillants (12) créateurs de surface supplémentaire sont agencés dans la cavité (10) de l'anode creuse (3), sur la surface intérieure (11) de celle-ci.

2. Dispositif selon revendication 1, caractérisé par le fait que les saillants (12) sont réalisés sous forme de nervures en saillie sur la surface intérieure (11).

3. Dispositif selon revendication 2, caractérisé par le fait qu'il est prévu deux ensembles de nervures qui se croisent.

4. Dispositif selon revendication 1, caractérisé par le fait qu'en son côté extérieur, l'anode creuse (3) est entourée de toutes parts par un écran d'espace sombre (14) qui présente également un bord (15) faisant saillie en direction de la deuxième électrode et se trouvant au même potentiel que l'écran d'espace sombre, ce bord formant de tous côtés, en vis-à-vis de la deuxième électrode (8), un interstice "$S_2$" de 10 millimètres au maximum.

5. Dispositif selon revendication 4, caractérisé par le fait qu'au moins un élément de couplage (17, 17a, 17b) est agencé sur au moins une partie du pourtour de l'écran d'espace sombre (14), cet élément de couplage étant sensiblement parallèle à la surface voisine de la deuxième électrode (8, 22), cela avec l'écartement de l'interstice "$S_2$".

6. Dispositif selon revendication 1, caractérisé par le fait qu'au moins une conduite d'amenée de gaz (13) conduit à la cavité (10).

7. Dispositif selon revendication 6, caractérisé par le fait que des ouvertures (19, 19a) pour un passage de gaz sont prévues dans les surfaces des parois de l'anode creuse (3) et de l'écran d'espace sombre (14), des grilles (20, 20a) imperméables aux fréquences élevées se trouvant dans ces ouvertures.

8. Dispositif selon revendication 7, caractérisé par le fait que des éléments-écrans (21) sont conjugués aux grilles (20, 20a) imperméables aux fréquences élevées.

9. Dispositif selon revendication 1, caractérisé par le fait qu'afin de traiter simultanément les deux côtés de substrats deux anodes creuses (3, 3') sont présentes en agencement à symétrie de réflexion, ces anodes creuses se complétant en une chambre sensiblement fermée, et par le fait que la deuxième électrode (8), ou encore le substrat (7) formant la deuxième électrode, peut passer dans le plan de symétrie entre les anodes creuses (3, 3').

10. Dispositif selon revendication 9, caractérisé par le fait que des éléments de couplage (17, 17') agencés parallèlement l'un à l'autre et à la deuxième électrode (8) ou encore au substrat (7) formant la deuxième électrode, sont disposés de part et d'autre du plan de symétrie.

11. Utilisation du dispositif selon revendication 1 en combinaison avec la conduite d'amenée de gaz réactifs pour réaliser, sur les substrats, des couches déposées à partir de la phase gazeuse.

## FIG.1

## FIG.2

## FIG.3

## FIG.4

**FIG.5**

**FIG.6**

**FIG.7**